Europäisches Patentamt

European Patent Office

Office européen des brevets

(19)

(11) Publication number: **0 200 124**
**A2**

# (12) EUROPEAN PATENT APPLICATION

(21) Application number: 86105428.6

(22) Date of filing: 18.04.86

(51) Int. Cl.⁴: **H 03 M 13/00**
**//G06F11/10**

(30) Priority: 02.05.85 JP 93636/85

(43) Date of publication of application:
05.11.86 Bulletin 86/45

(84) Designated Contracting States:
DE FR GB IT

(71) Applicant: HITACHI, LTD.
6, Kanda Surugadai 4-chome Chiyoda-ku
Tokyo 100(JP)

(72) Inventor: Horikawa, Mari
4-401 Corp. Tachibana 21-27, Toyohara-cho
Hiratsuka-shi Kanagawa-ken(JP)

(72) Inventor: Kawamura, Satoshi
F1202, 1-28 Deiki Kanazawa-ku
Yokohama-shi Kanagawa-ken(JP)

(72) Inventor: Saiki, Eisaku
Yoshida Apt. 246 594, Yoshida-cho Totsuka-ku
Yokohama-shi Kanawaga-ken(JP)

(72) Inventor: Miyazawa, Syoichi
Hachimanyama Apt. 223 1545, Yoshida-cho Totsuka-ku
Yokohama-shi Kanawaga-ken(JP)

(72) Inventor: Yamauchi, Tsukasa
Hachimanyama Apt. 543 1545, Yoshida-cho Totsuka-ku
Yokohama-shi Kanawaga-ken(JP)

(72) Inventor: Endo, Takeyuki
3-1-26, Gakuennishi-machi
Kodaira-shi Tokyo(JP)

(72) Inventor: Minorikawa, Kazuo
3-6-20, Koyata
Iruma-shi Saitama-ken(JP)

(72) Inventor: Toyama, Shoichiro
549-1, Ogikubo
Odawara-shi Kanawaga-ken(JP)

(74) Representative: Altenburg, Udo, Dipl.-Phys. et al,
Patent- und Rechtsanwälte
Bardehle-Pagenberg-Dost-Altenburg-Frohwitter &
Partner Postfach 86 06 20
D-8000 München 86(DE)

(54) Decoding method and encoder-decoder for cyclic codes.

(57) An encoder/decoder for detecting and correcting a burst error of a cyclic code uses a two-way feedback shift register including a chain of $\ell$ pieces of flip flops and exclusive OR gates corresponding to generator polynomials. A received code word is provided to the two-way feedback shift register in a forward shift direction during a decoding mode. After inputting the received code word into the feedback shift register, if a syndrome is not equal to zero, the shifting direction of the feedback shift register is changed over, so that the shifting of the contents of the flip flops is repeated until a zero tester detects that outputs of selected ($\ell$-m) pieces of the flip flops become all-zero. When the zero tester detects the all-zero, the contents of remained m pieces of the flip flops are provided as an error pattern of the received code word.

./...

## FIG. 4

Hitachi, Ltd.

April 17, 1986
H6972-EP

0200124

## BACKGROUND OF THE INVENTION

This invention relates to a method for detecting and correcting errors and an encoder/decoder with respect to this method, and more paticularly, to a decoding method and an encoder/decoder suitable for detecting and correcting errors of a cyclic code word having an arbitrary data length with high speed.

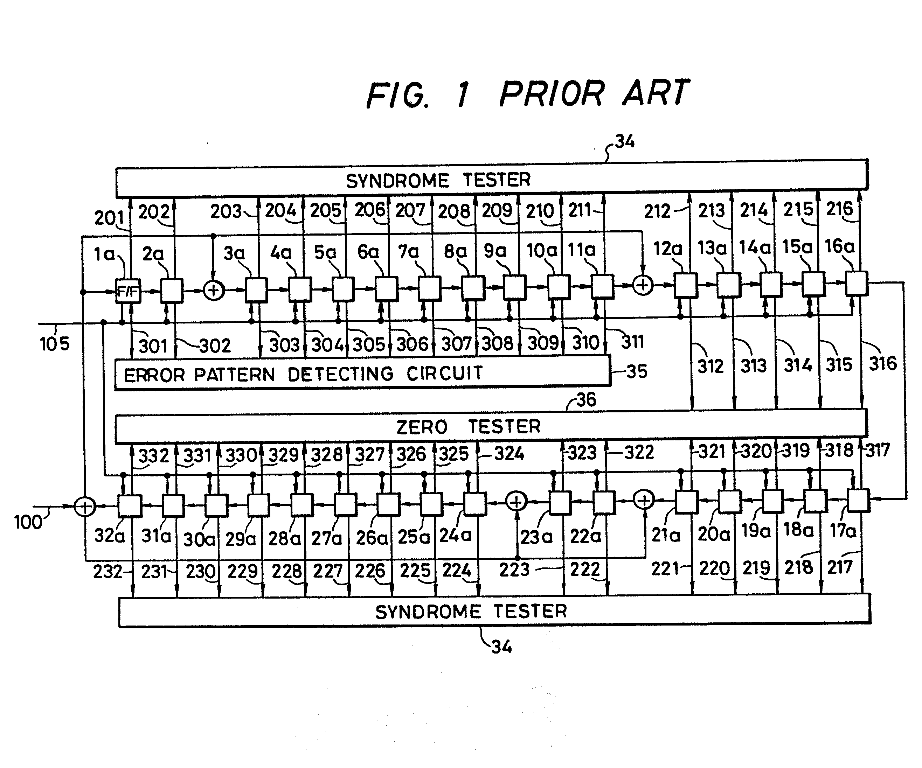

Referring to Fig. 1, there is shown an example of a decoder of a conventional cyclic code. The decoder shown in Fig. 1 is based on the following generator polynomial.

$$g(x) = (x^{21}+1) \cdot (x^{11}+x^2+1) \quad \dots\dots\dots\dots\dots\dots\dots\dots\dots\dots\dots\dots\dots \quad (1)$$

The decoder consists of flip flops (hereinafter referred to as F/Fs) 1a to 32a which are linked to each other in a chain-like configuration through exclusive OR gates inserted in predetermined positions corresponding to the generator polynomial $g(x)$, a syndrome tester 34, an error pattern detecting circuit 35 and a zero tester 36. Output signals of the F/Fs 1a to 32a are input to the syndrome tester 34. Output signals of the F/Fs 1a to 11a are input to the error pattern detecting circuit 35. Output signals of the F/Fs 12a to 32a are input to the zero tester 36.

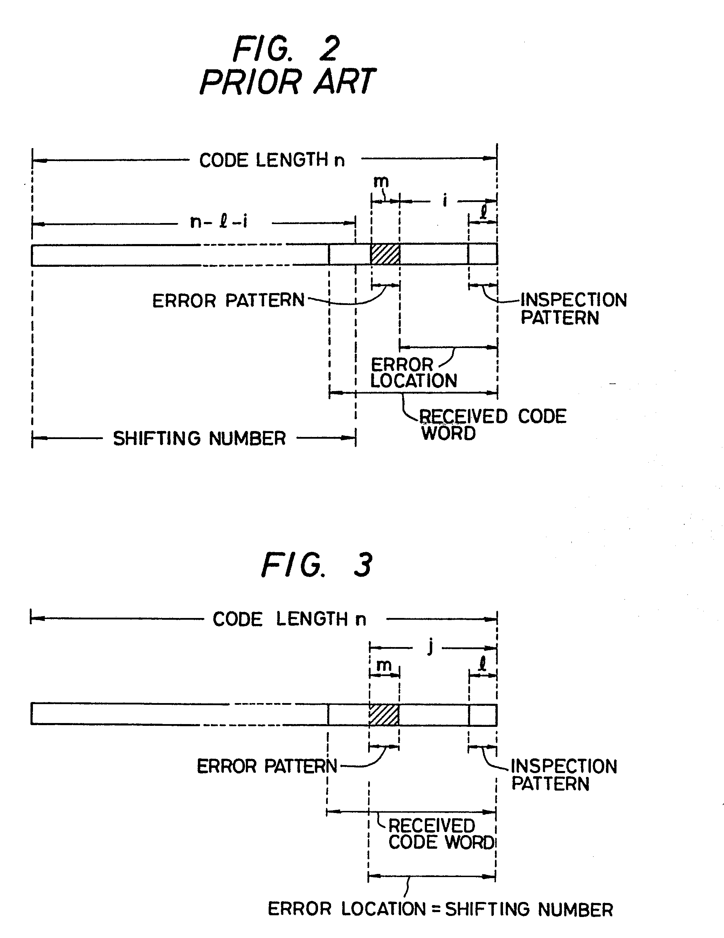

Fig. 2 illustrates a schematic diagram of a code word, which is to be supplied to the decoder shown in Fig. 1. Suppose that a code length of a code word according to the generator polynomial is n bits, a degree of the $g(x)$ is $\ell$, a degree of an error pattern $B(x)$ is m, and an error location is i bits, equalities of $\ell=32$ and $m=11$ are established in accordance with the equation (1) as regards the present decoder.

Next, operations of the decoder shown in Fig. 1 will be explained.

A received code word F(x) supplied to a signal line 100 is shifted in due order from F/F 1a while being subjected to a feedback of the F/Fs 1a to 32a. Namely, a feedback shift register of Fig. 1 can be defined as a dividing circuit, in which the g(x) is a divisor and a surplus is obtained after the input of the F(x) has been executed.

At this time, contents of the feedback shift register can be expressed such as:

$$S'(x) \equiv x^{\ell} \cdot F(x) \equiv x^{\ell} \cdot x^{i} B(x) \quad (\bmod\ g(x)) \quad \ldots\ldots\ldots\ldots\ldots\ldots \quad (2)$$

Outputs 201 to 232 of the F/Fs 1a to 32a of the feedback shift register are supplied to the syndrome tester 34. If all the outputs 201 to 232 of the F/Fs come to zero, the syndrome tester 34 decides that there is no error in the received code word F(x). On the contrary, if they are not zero, the syndrome tester 34 decides that errors exist in the received code word F(x). Consequently, an error pattern extraction will be followed.

Low-order 11 bits of the feedback shift register, that is, the outputs of the F/Fs 1a to 11a, are provided to the error pattern detecting circuit 35. Also, high-order 21 bits thereof, that is, the outputs of the F/Fs 12a to 32a, are supplied to the zero tester 36.

When the syndrome tester 34 detects that there is the error , the feedback shift register is shifted in the forward direction. The shifting is repeated in the feedback register until the zero detector 36 detects that all the outputs of the F/Fs 12a to 32a become zero. Immediately after the detection, the shifting halts. At this time, the low-order 11 bits of the feedback shift register, that is, the outputs of the F/Fs 1a to 11a, which are connected to the error pattern detecting circuits 35, are extracted as the error pattern.

Since the error location is at $\underline{i}$ bits in the code word depicted in Fig. 2, the zero tester 36 will detect all-zero after the shiftings of $(n-\ell-i)$ times are executed. Under such circumstances, the contents of the feedback shift register are manifested by the following formula.

$$x^{n-\ell-1} \cdot S'(x) \equiv x^n \cdot B(x) \equiv B(x) \quad (\text{mod } g(x)) \quad \ldots\ldots\ldots\ldots\ldots\ldots \quad (3)$$

Here, low-order $\underline{m}$ stages ($m=11$) of the feedback shift register can be extracted as the error pattern, that is, $B(x)$.

The generator polynomial $g(x)$ usually employed for error correction is formulated as below. Both of the following formulae (4) and (5) are utilized for obtaining a burst error within the 11 bits.

$$g(x) = (x^{24}+1) \cdot (x^{11}+x^2+1) \quad \ldots\ldots\ldots\ldots\ldots\ldots\ldots\ldots\ldots\ldots \quad (4)$$

or

$$g(x) = (x^{22}+1) \cdot (x^{12}+x^{11}+ \ldots +x+1)$$
$$\cdot (x^{11}+x^7+x^6+x+1) \cdot (x^{11}+x^9+x^7+x^6+x^5+x+1) \quad \ldots\ldots\ldots\ldots \quad (5)$$

While code lengths of the code words corresponding to the formulae (4) and (5) are 42,987 and 585,442, the data lengths generally used codes come to 4,096 bytes (32,768 bits) at the highest. A conventional decoder, therefore, requires tremendously much time for decoding and is of little practical use.

As a method to cope with such a problem, there is proposed a highspeed decoding method using a Chinese remainder theorem. This decoding method, however, involves some problems, that is, an arithmetic function having to be provided for obtaining the error location and an application being confined to only the decoding since the apparatus is constituted by a parallel dividing circuit, and an encoder has to be additionally installed.

Excepting the above-mentioned method, another decoding method using shortened cyclic codes has been proposed. This method, however, needs to seek a difference ($\alpha$ bits) between the code lengths and the data lengths and compute the following correction polynomial P(x) beforehand.

$$P(x) = x^{\alpha} \mod g(x) \quad \dots\dots\dots\dots\dots\dots\dots\dots\dots\dots\dots\dots \quad (6)$$

Concerning the error correction performed by the feedback shift register and the Chinese remainder theorem are described in "1983 Data Book of Advanced Micro Devices, Inc., pages 7-135 to 149, Burst Error Processor". Also, a pending United States Patent Application Serial No. 669,423, assigned to the same assignee as the present application, discloses a decoder for a Fire code.

## SUMMARY OF THE INVENTION

It is an object of the present invention to provide a decoding method for a cyclic code applicable to a received code word having an arbitrary data length and a decoder for a cyclic code, which corrects errors of a received code word at high speed.

It is another object of the invention to provide a decoding method for a cyclic code applicable to several generator polynomials and an encoder/decoder with respect to this method.

To accomplish the above object, according to the present invention, all outputs of flip flops of $\ell$ pieces of a feedback shift register are checked to be zero or not zero when a received code word of a cyclic code is input to the feedback shift register, the shift direction of the feedback shift register is reversed when the all outputs of the flip flops are not zero, the shifting of the reverse directions is repeated until all outputs of the flip flops of (ℓ-m) pieces become zero, and all outputs of the remained flip flops of m pieces are extracted as an error pattern when the all outputs of the flip flops of (ℓ-m) pieces are detected to be zero.

Further, according to the present invention, in an encoder/decoder comprising a feedback shift register where flip flops of ℓ pieces are linked to each other through exclusive OR gates that are disposed at predetermined positions, a syndrome tester detecting that all outputs of the flip flops are zero, an error pattern detecting circuit connected to the flip flops of m pieces and a zero tester detecting that all outputs of the flip flops of (ℓ-m) pieces, there is provided a change-over means for changing over a shifting direction of the feedback shift register when the syndrome tester detects that syndrome≠0, until the zero tester detects all-zero of the outputs of the flip flops of (ℓ-m) pieces.

Next, a principle of the present invention will be explained hereinafter.

The cyclic code is defined as a linear code which is unchangeable for a cyclic shift. In general, if a polynomial $g(x)$ is a factor of $(x^n-1)$, a set of code polynomials which have degrees lower than $(n-1)$ and can be devided by the polynomial $g(x)$ is a cyclic code. For example, a general polynomial for a burst error correction code, which is a kind of the cyclic code, is generally expressed as the following formula.

$$g(x) = (x^C+1) \prod_{i=1}^{h} Pi(x) \quad \dots\dots\dots\dots\dots\dots\dots\dots\dots\dots \quad (7)$$

where $Pi(x)$ represents an irreducible polynomial.

Therefore, a discretionary generator polynomial of the cyclic code can be manifested as follows:

$$g(x) = x \cdot q(x)+1 \quad \dots\dots\dots\dots\dots\dots\dots\dots\dots\dots\dots \quad (8)$$

Namely, $g(x)$ and $x$ are primes with respect to each other.

As for polynomials $P(x)$ and $Q(x)$ with integer coefficients, if the two polynomials are primes with respect to each other, certain polynomials $a(x)$ and $b(x)$ exist. Therefore, the following equation (9) is established.

$$a(x) \cdot P(x) + b(x) \cdot Q(x) = 1 \quad \dots\dots\dots\dots\dots\dots\dots\dots \quad (9)$$

When $P(x)$ is replaced by $g(x)$ and $Q(x)$ is replaced by $x$ in the equation (9), an equation (10) is held.

$$a(x) \cdot g(x) + b(x) \cdot x = 1 \quad \dots\dots\dots\dots\dots\dots\dots\dots \quad (10)$$

Hence,

$$b(x) \cdot x \equiv 1 \quad (\bmod\ g(x)) \quad \dots\dots\dots\dots\dots\dots\dots\dots \quad (11)$$

Namely, in connection with a congruent modulus $g(x)$, the following inverse element of $x$ exists.

$$x^{-1} \equiv b(x) \quad (\bmod\ g(x)) \quad \dots\dots\dots\dots\dots\dots\dots\dots \quad (12)$$

Here, as the nature of the generator polynomial $g(x)$, the next formula is held.

$$x^n \equiv 1 \quad (\bmod\ g(x)) \quad \dots\dots\dots\dots\dots\dots\dots\dots \quad (13)$$

where $n$ is the code length of the cyclic code word according to the generator polynomial $g(x)$.

Accordingly, the inverse element $x^{-1}$ whose existence is verified by the formulae (7) to (12) is multiplied by $\underline{n}$,

$$1 \equiv x^{-n} \qquad (\mod g(x)) \quad .................................. \quad (14)$$

Further, when each side of the equation (14) is multiplied by $x^k$,

the result becomes as follows:

$$x^k \equiv x^{k-n} \qquad (\mod g(x)) \quad ............................... \quad (15)$$

For clarity $\underline{k}$ is the integer with nature of $0 < k < n$ in the equation (15).

The equation (15) can be modified as below:

$$x^k = x^{-(n-k)} \qquad (\mod g(x)) \quad ............................... \quad (16)$$

Therefore, the content of the feedback shift register after shifting the feedback shift register, which has an initial content

$f(x)$, $\underline{k}$ times in the forward direction, is identical with that obtained after shifting it $(n-k)$ times in the reversed direction.

Namely, the following equation is established.

$$x^k f(x) \equiv x^{-(n-k)} f(x) \qquad (\mod g(x)) \quad ..................... \quad (17)$$

In considering the above-mentioned points, it becomes to largely reduce a great number of futile shifting operations incident to the conventional decoding method.

As it is mentioned before, in the present invention, if the syndrome is not zero when the received code words have just input to the feedback shift register, the zero tester is capable of detecting zero by shifting the feedback shift register $\{n-(n-\ell-1)\}$, that is,

$(\ell+1)$ times in the reversed direction instead of shifting it $(n-\ell-1)$

times in the forward direction. Since the error pattern is detected with the high-order $\underline{m}$ bits of the feedback shift register, the number of shifting actually decreases by $(\ell-m)$ times. The feedback shift

register is shifted $\underline{j}$ times in the reversed direction which $\underline{j}$ can be

- 8 -

0200124

obtained by the following equation.

$$\ell + i - (\ell - m) = i + m = j \quad \dots\dots\dots\dots\dots\dots\dots\dots\dots\dots \quad (18)$$

Fig. 3 illustrates a schematic diagram showing a state of a code word, when the feedback shift register is shifted $j$ times in the reverse direction according to the present invention.

Since the above mentioned principle of the present invention depends on only the nature of the cyclic code, an applicable data length is discretional, if the data length shorter than the code length.

## BRIEF DESCRIPTION OF THE DRAWINGS

Fig. 1 shows a block diagram of an encoder/decoder according to a prior art,

Fig. 2 illustrates a schematic diagram showing a state of a code word shifted in a forward direction according to the prior art,

Fig. 3 illustrates a schematic diagram showing a state of a code word shifted in a reversed direction by a feedback shift register for explaining the present invention,

Fig. 4 shows a block diagram of an embodiment of an encoder/decoder according to the present invention,

Fig. 5 shows a circuit diagram of a main part of the encoder/decoder shown in Fig. 4,

Fig. 6 illustrates a flow chart showing an algorithm for decoding the received code word according to the present invention, and

Figs. 7 and 8 show circuit diagrams of another embodiments of encodes/decoders according to the present invention, respectively.

## DESCRIPTION OF THE PREFERRED EMBODIMENTS

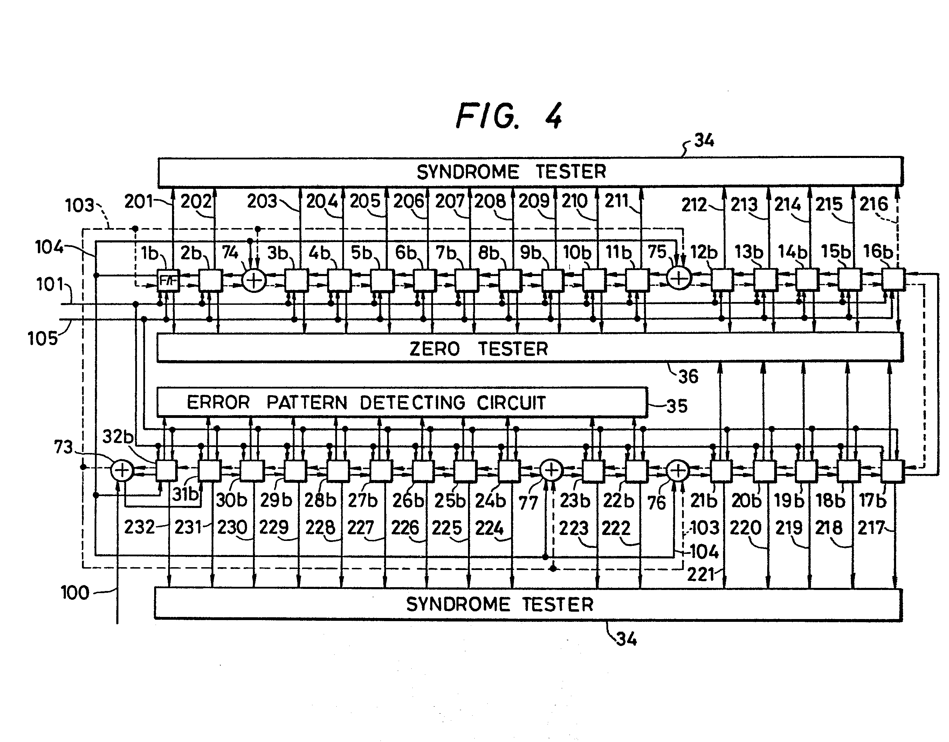

Referring to Fig. 4, there is shown an embodiment of an encoder/decoder according to the present invention.

A decoder shown in Fig. 4 is one which is based on the equation (1) as in the case of the decoder shown in Fig. 1. This decoder consists of a bidirectional feedback shift register including flip flops (F/Fs) 1b to 32b which are linked to each other in a chain-like configuration through exclusive OR gates 73 to 77 inserted into predetermined positions corresponding to the generator polynomial g(x) in the formula (4), a syndrome tester 34 to which output signals of the F/Fs 1b to 32b are input, a zero tester 36 to which output signals of the F/Fs 1b to 21b are supplied and an error pattern detecting circuit 35 to which output signals of the F/Fs 22b to 32b are input. The exclusive OR gates 73 to 77 are positioned in the zero-th, 2nd, 11th, 21st and 23rd stages. The flip flops 1b to 32b unlike the F/Fs 1a to 32a shown in Fig. 1 reverse the shifting direction corresponding to signals that are supplied to a control line 101. Another different point from the circuit shown in Fig. 1 is that connecting relations between the zero tester 36, the error pattern detecting circuit 35 and the F/Fs 1b to 32b are reversed.

Suppose that the received code word is provided by the forward-direction-shifting from a signal line 100 of the feedback shift register shown in Fig. 4, at the input-termination the contents S'(x) of the feedback shift register can be expressed as follows:

$$S'(x) \equiv x^{\ell}F(x) \equiv x^{\ell+j-m}B(x) \qquad (\text{mod } g(x)) \quad \dots\dots\dots\dots\dots \quad (19)$$

where $\underline{j}$ is the error location as shown in Figs. 2, 3. Since the decoding is effected from the end of the code word, a relation of j = i + m is established.

If S'(x) = 0, that is, there is no error in the received code word, the syndrome tester 34 detects that all outputs of the lines 201 to 232 are zero. If not, an error is detected. In the latter case, so far as the conventional decoding method is concerned, the shifting continues to be carried out in the forward direction till the zero tester 36 detects zero. In the decoding method according to the present invention, however, the shifting direction is inversely changed over by inverting a signal-state of the control line 101; and the inverse shifting is repeated until the zero tester 36 detects all zero. It is to be noted that a direction indicated by a dotted arrowhead in Fig. 4 is defined as the forward direction, whereas a direction pointed by an arrowhead of solid line is the reversed one.

Let $j$ be the error location (the most significant bit of the error pattern), the following equation is settled, whereby the error pattern can be obtained.

$$x^{\ell-j}F(x) \equiv x^{\ell-m}B(x) \qquad (\mathrm{mod}\ g(x)) \quad \ldots\ldots\ldots\ldots\ldots\ldots\ldots\ldots (20)$$

The left side of the equation (20) indicates that the feedback shift register was shifted $j$ times in the reversed direction after computation of the syndrome S'(x) has been finished; and the right side thereof indicates that high-order $m$ bits of the feedback shift register are equivalent to the pattern B(x). When the zero tester 36 detects all-zero, therefore, it is possible to extract the error pattern B(x) by seeking contents of the F/Fs 22b to 32b by means of the error pattern detecting circuit 35.

Namely, according to the decoding method of the present invention, the shifting number required for obtaining the error pattern coincides with the error location and hence it is not probable to exceed the data lengths of the received code word even in the worst case (the burst error exists within 11 bits inclusive of the top bit of the received code word). Owing to this advantage, it is possible to carry out decoding operation at a high speed. In case that the error pattern can not be gained by shifting the feedback shift register certain times corresponding to the data lengths, the error is deemed uncorrectible.

In an encoding mode executed by the encoder/decoder according to the present invention, the code word is input from the input terminal 100 after directing the shifting forward, an inspection pattern remains in the feedback shift register at the completion of inputting. At this time, the contents of the feedback shift register are taken out, thus performing the encoding in the same way as the conventional one.

As can be understood from the above description, the method of the present invention rests with only the nature of the cyclic code, so that a length of applied data is absolutely discretionary on the condition that it does not exceed the code length.

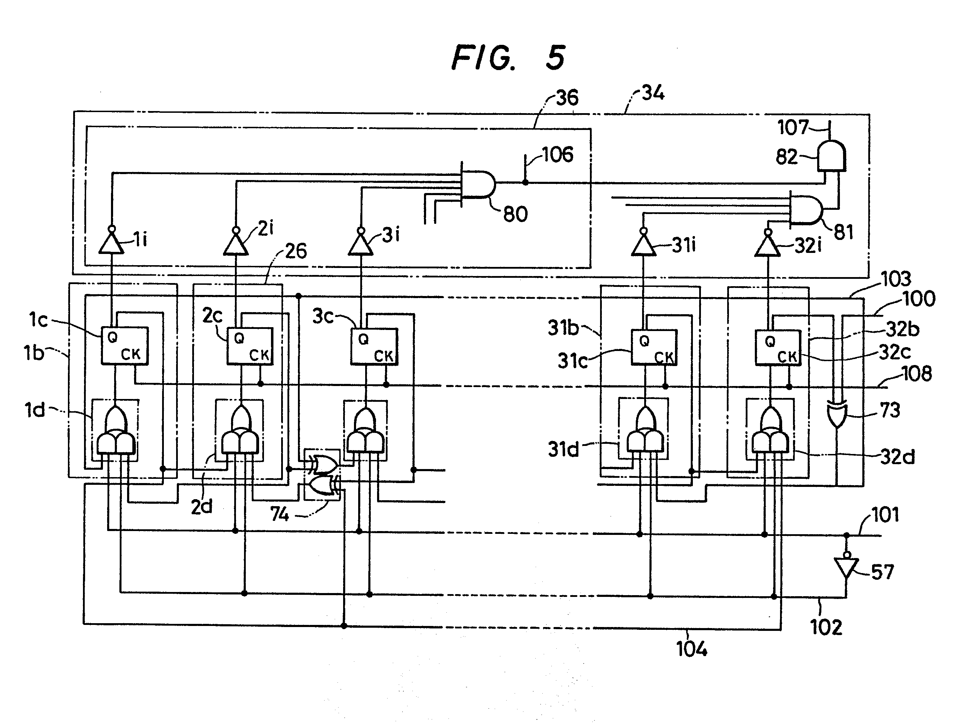

Fig. 5 is circuit diagram of an encoder/decoder which includes the bidirectional feedback shift register (shown in Fig. 4). In Fig. 5, 1b to 32b represent the F/Fs 1b to 32b shown in Fig. 4 which correspond to the respective stages of the feedback shift register. The F/Fs 1b – 32b are constituted by flip flop (F/F) circuits 1c to 32c and alternative circuits 1d to 32d. One of the alternative circuits 1d to 32d comprises an OR gate and two AND gates. As one example, the alternative circuit 2d is described here. When the control line 101 is made to assume high level, a signal line 102 is rendered low in level with aid of an inverter 57. In the alternative circuit 2d, of two input signals (output of the F/F circuit 1c and output of the F/F circuit 3c) is selected the output of the F/F circuit 1c. The output of the F/F circuit 1c becomes an input signal of the F/F circuit 2c by means of a clock emitted from a signal line 108. While on the other hand, if the control line 101 is made to assume a low level, the signal line 102 assumes high level. As a result, the output of the alternative circuit 2d becomes equal to that of the F/F circuit 3c. In Fig. 5, a part, defined from the 4th stage to the 30th stage, of the feedback shift register is omitted for simplification. As regards the alternative circuit and the F/F circuit, however, there are a series of the same circuit constitutions. When the control line 101 reaches the high level, the contents of the feedback shift register are shifted in the forward direction. Inversely, when the control line 101 goes down to the low level, the contents of the same register are shifted in the reversed direction. Inverters denoted by 1i to 32i are provided at the respective output terminals (inclusive of the omitted portions) of the F/Fs 1b to 32b. The outputs of the F/Fs 1b to 21b are input through the inverters 1i to 21i to an AND gate 80; and the outputs of the F/Fs 22b to 32b are likewise input through the inverters 22i to 32i to an AND gate 81. The AND gate 80 and the inverters 1i to 21i correspond to the zero tester 36 shown in Fig. 4; and AND gates 81 and 82, the AND gate 80 and the inverters 1i to 32i correspond to the syndrome tester 34.

Each procedure for both encoding and decoding will hereinafter be described.

(I) Encoding

At first, the F/F circuits 1c - 32c are cleared (set to zero). The control line 101 is set at the high level. The data are, on a bitwise basis, input in due order from the signal line 100. The contents of the feedback shift register are bit by bit shifted in the forward direction at every leading edges of clock signals provided from a signal line 108. The contents of the feedback shift register correspond to the inspection pattern, just when the data input is terminated. This inspection pattern is added behind the data thereby to complete the encoding operation.

(II) Decoding

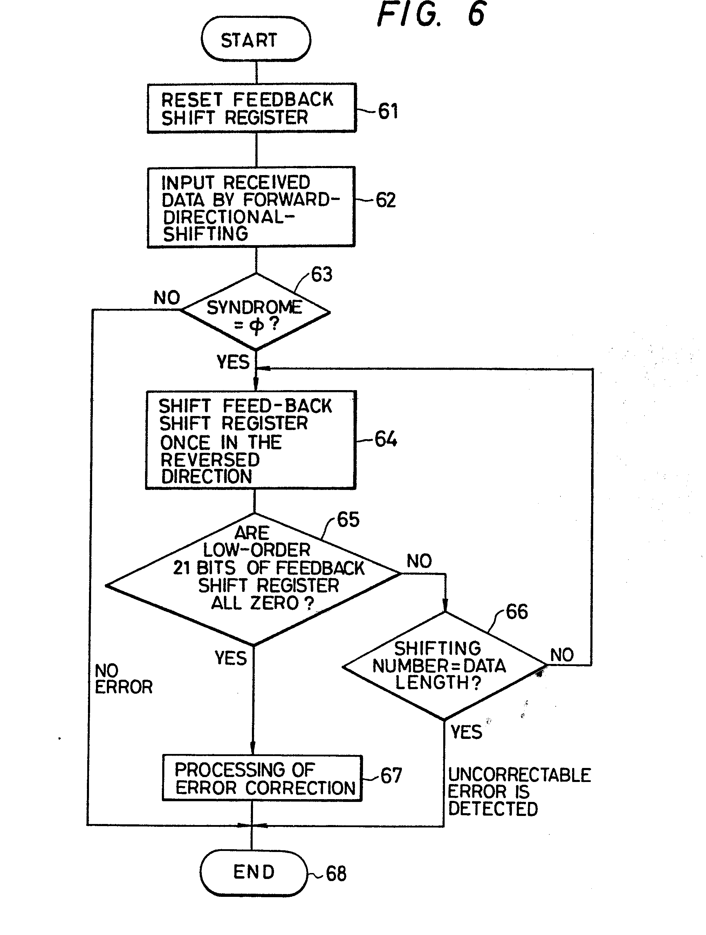

Referring to Fig. 6, there is shown an algorithm of the decoding method according to the present invention. Decoding operations performed by the apparatus shown in Fig. 4 will hereinafter be described in accordance with a flow depicted in Fig. 6.

Step 61:

The feedback shift register is reset. To be tangible, the F/F circuits 1c - 32c are reset.

Step 62:

The control line 101 is set at the high level, and the received code data are consecutively input from the signal line 100.

Step 63:

The syndrome tester 34 judges as to whether the syndrome S' is zero or not.

If the syndrome S' is zero, all the stages of the feedback shift register are zero and the syndrome is also zero, when an output 107 of the AND gate 82 reaches the high level at the completion of the inputting of the received code data. Namely, it is judged that there is no error. Consequently, the decoding operation comes to an end.

If the syndrome S' is not zero, and when the output 107 of the AND gate 82 assumes low level, this indicates that the syndrome is not zero. Hence, it can be considered that some errors have been detected.

In this case, the shifting operation continues to be performed in the reversed direction by steps 64, 65, 66 till the zero tester 36 detects all-zero.

Step 64

The signal line 101 is set at the low level. The clock signal is emitted from the signal line 108 in order to shift the feedback shift register by one bit in the reversed direction.

Step 65

The AND gate 80, viz., the zero tester 36, judges as to whether all the outputs of the F/F circuits 1c - 21c are zero or not.

When an output 106 of the AND gate 80 is at the low level, it is required to get back to the step 64, and further, the shifting operation is repeated in the reversed direction till the output 106 thereof assumes high level.

Given that the output 106 of the AND gate 80 reaches the high level, this means that the error location and the error pattern have been extracted, so that the next action is to move to a step 67 where the processing of error correction is carried out. In this case, high-order 11 bits (contents of the F/Fs 22b to 32b) of the feedback shift register can be defined as the obtained error pattern, and the shifting number calculated after inverting the shifting direction indicates a top-bit location (error location) of the error pattern.

Step 66

If the shifting number reaches the lengths (bits) of the received data but the output 106 does not assume high level, it can be considered that there exists an uncorrectable error.

Step 67

Where an error pattern is obtained by the above-described steps, the error in the received code word can be corrected if the received code word and the error pattern be exclusively ORed from the counted error location.

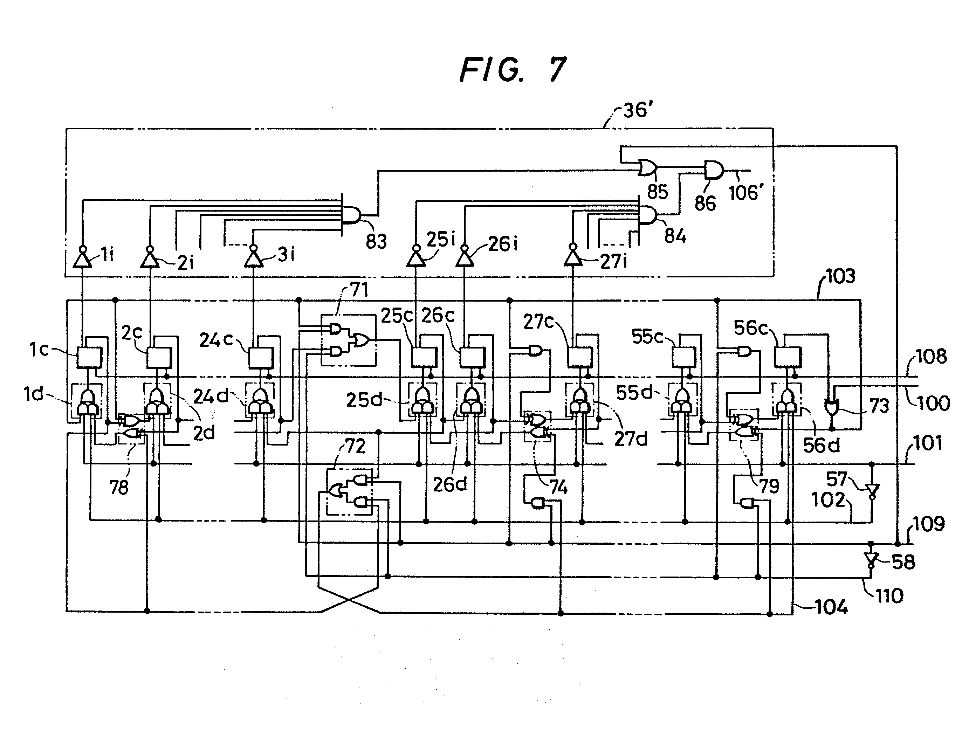

Next, another embodiment will be described in connection with a circuit diagram of an encoder/decoder shown in Fig. 7. The encoder/decoder shown in Fig. 7 comprises a two-way feed-back shift register for correcting burst errors based on generator polynomials of 32 bits and 56 bits. The two-way feed-back shift register having 56 stages includes F/F circuits 1c to 56c and alternative circuits 1d to 56d through exclusive OR gates inserted into predetermined positions corresponding to the generator polynomial g(x) in the formulae (4) and (5). In case of the formulae (5), exclusive OR gates are positioned in the zero-th, 1st, 5th, 9th, 11th, 12th, 14th, 15th, 16th, 17th, 19th, 22nd, 31st, 36th, 37th, 38th, 39th, 41st, 45th, 49th and 55th stages. The numerals 78 and 79 denote the exclusive OR gates in the 1st and 55th stages. The remaining gates are eliminated in Fig. 7. Function of the signal supplied to the control line 101 is the same one as the signal provided to the control line 101 shown in Fig. 5. In Fig. 7, a part, defined from the 3rd stage to the 23rd stage and from the 28th stage to the 54th stage is omitted from simplification. As regards the alternative circuit and the F/F circuit, however, there are a series of the same circuit constitutions. When the control line 101 becomes the high level, the contents of the feedback shift register are shifted in the forward direction. Also, when the control line 101 goes down to the low level, the contents of the same register are shifted in the reversed direction. Inverters denoted by 1i to 27i are provided at the respective output terminals (inclusive of the omitted portions) of the

F/F circuits 1c to 56c.

The numerals 109 and 110 denote signal lines for selecting 32 bits error correction mode or 56 bits error correction mode. When the signal line 109 reaches the high level, the signal line 110 goes down to the low level by an inverter 58, so that the 32 bits error correction mode is selected. On the contrary, when the signal line 109 goes down to the low level, the signal line 109 becomes the high level, so that the 56 bits error correction mode is selected. Therefore, the exclusive OR gates like the gates 74 and 79 are selected in response to the signal supplied to the signal line 109, too. The numerals 71 and 72 designate selective circuits, each of which comprises an OR gate and two AND gates, respectively. In the 32 bits error correction mode, the content of the F/F circuit 56c is shifted to the F/F circuit 25c through the selective circuit 71 in the forward direction, or the content of the F/F circuit 25C is shifted to the F/F circuit 56C through the alternative circuit 72 in the reverse direction. In the 56 bits error correction mode, the content of the F/F circuit 24c is shifted to the F/F circuit 25c through the selectrive circuit 71 in the forward direction, or the content of the F/F circuit 25C is shifted to the F/F circuit 24c through the selective circuit 72 in the reverse direction. Namely, in the 32 bits mode, a part of the feedback shift register, that is, from the 25th stage to the 56 stage thereof, is used.

Further, the outputs of the F/F circuits 1c to 24c are provided through the inverters 1i to 24i to an AND gate 83, and the outputs of the F/F circuits 25c to 45c are provided through the inverters 25i to 45i to an AND gate 84. The output of the AND gate 83 and the signal line 109 are provided to an OR gate 85 and the outputs of the OR gate 85 and the AND gate 84 are supplied to an AND gate 86. The output of the AND gate 86 is an all-zero detection signal of the low order 45 stages of the feedback shift register in the 32 bits burst error correction mode or the low order 21 stages thereof in the 56 bits burst error correction mode, and becomes the high level when the all-zero of them is detected. That is, the numeral 36' denotes the zero tester for both the 32 and 56 bits correction modes.

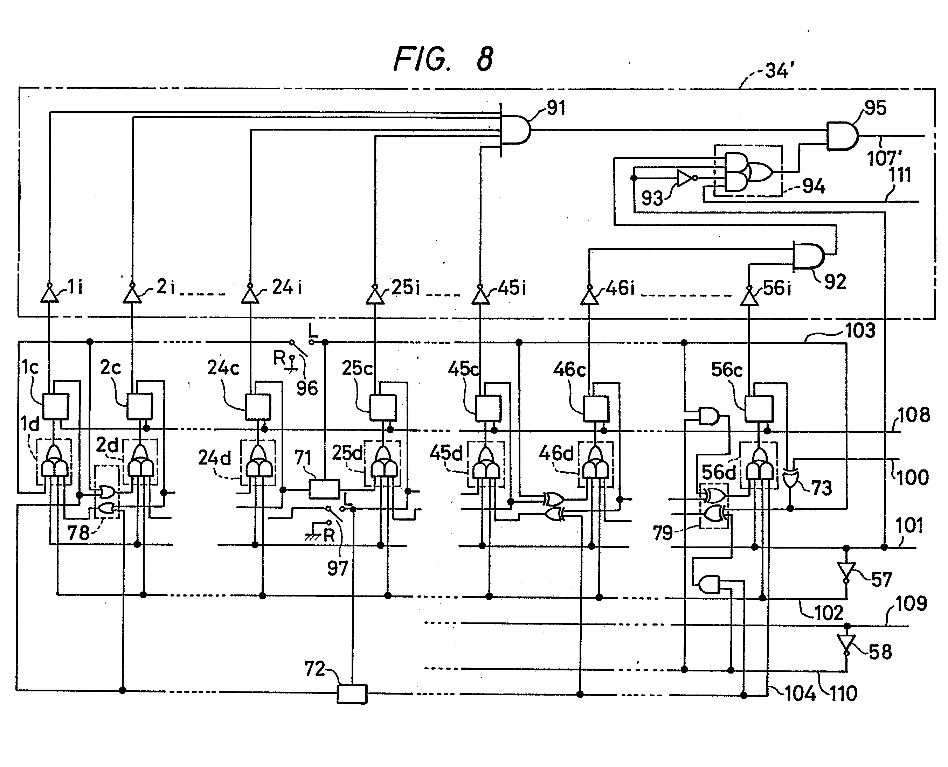

Although the syndrome tester is not depicted in Fig. 7, it is necessary to construct it·like as Fig. 5. Fig. 8 shows a circuit diagram of the zero tester and the syndrome tester, which can be used in the 32 bits and 56 bits burst error correction modes. An AND gate 91 is used as the zero tester in the 32 bits and 56 bits burst error correction modes together with switch circuits 96 and 97. In the latter mode, the switch circuits 96 and 97 are turned to L terminals, respectively. When the outputs of the F/F circuits 1c to 45c are all-zero, the output of the AND gate 91 becomes the high level. In the former mode, the switch circuits 96 and 97 are turned to R terminals, respectively. If the F/F circuits 1c to 24c are cleared at the start of the 32 bits correction mode, the outputs of the F/F circuits 1c to 24c stay at the lower level during the mode. Therefore, when the outputs of the F/F circuits 25c to 56c are all-zero, the output of the AND gate 91 becomes the high level.

The outputs of the inverters 46i to 56i are provided to an AND gate 92. The AND gates 91 and 92, an inverter 93, an alternative circuit 94 and an AND gate 95 construct the syndrome tester 34'. A signal line 111 is set the high level. When the data input from the signal line 100 is terminated, the syndrome is detected. In case of the syndrome=0, an output 107' of the AND gate 95 becomes the high level, and in case of the syndrome≠0, the output 107' of the AND gate goes down to the low level. In the latter case, as described before, the control line 101 is set at the low level. Therefore, when the output of the AND gate 91 reaches the high level, the outputs of the inverters 46i to 56i indicate the error pattern. Further, since the signal line 111 is at the high level and the control line 101 is at the low level, the output 107' of the AND gate 95 becomes the high level at the zero-detection.

In the embodiments shown in Figs. 7 and 8, the error pattern is obtained by the above-described steps in the first embodiment and the error in the received code word can be corrected if the received code word and the error pattern and exclusively ORed from the error

locations.

word and the error pattern and exclusively ORed from the error

locations.

Hitachi, Ltd.

April 17, 0280124
H 6972-EP

CLAIMS

1. A decoding method for decoding a cyclic code by using a feedback shift register which comprises $\ell$ pieces of flip flops together with exclusive OR gates inserted into positions corresponding to a generator polynomial for the cyclic code, comprising:

step for inputting a received code word to the feedback shift register in a forward shift direction,

step for detecting a syndrome just after finishing to input said received code word,

step for changing over a shifting direction of the feedback shift register when the syndrome is not equal to zero,

step for repeating the shifting of the feedback shift register in the reverse direction until outputs of selected $(\ell-m)$ pieces of the flip flops become all-zero, and

step for providing outputs of remained $m$ pieces of the flip flops as an error pattern when said outputs of selected $(1-m)$ pieces of the flip flops become all-zero.

2. A decoding method according to claim 1, wherein

said repeating step comprises step of detecting outputs of low-order $(\ell-m)$ pieces of the flip flops.

3. A decoding method according to claim 2, wherein

said providing step provides outputs of high-order $m$ pieces of the flip flops.

0200124

4. A decoder for decoding a cyclic code based on a generator polynomial having a degree l, comprising:

a two-way feedback shift register which includes a chain of l pieces of flip flops (1C~32C), exclusive OR gates (73~77) inserted into positions of said chain corresponding to the generator polynomial and an input terminal (100) receiving a code word,

a syndrome tester (34), to which all outputs of said flip flops are supplied, for detecting a syndrome of said received code word,

a zero tester (36), to which outputs of selected (l-m)pieces of said flip flops are supplied, for detecting said outputs of the selected (l-m) pieces all-zero,

an error pattern detecting means (35), to which outputs of remained m pieces of said flip flops are supplied, for detecting an error pattern of said received code word, and

means (101) for changing over a shift direction of said two-way feedback shift register when said syndrome tester detects said syndrome not zero.


5. A decoder according to claim 4, wherein said zero tester receives outputs of low-order (l-m) pieces (1C~21C) of said flip flops.


6. A decoder according to claim 5 wherein said error pattern detecting means receives outputs of high-order m pieces (22C~32C) of said flip flops.

7. A decoder according to claim 4, wherein

said two-way feedback shift register further comprises alternative circuits (1d~32d), each of which is attached to an input terminal of each of said flip flops and receives a control signal, from said change over means.

8. An encoder/decoder for a cyclic code based on a generator polynomial, comprising:

two-way feedback shift register means which includes a chain of flip flops (1C~56C) and alternative circuits (1d~56d) connected to inputs of said flip flops, exclusive OR gates (73~79) inserted into positions of said chain corresponding to several generator polynomials and input terminal (100) receiving a code word, a number of said flip flops coincides with the largest degree of said generator polynomials,

means for selecting l pieces of said flip flops and said alternative circuits for constructing a two-way feedback shift register corresponding to the generator polynomial of said received code word,

a syndrome tester (34), to which all outputs of said secected flip flops are supplied, for detecting a syndrome of said received code word,

a zero tester (36), to which outputs of low-order (1-m) pieces of said selected flip flops are supplied, for detecting said outputs of said low-order (1-m) pieces,

an error pattern detecting means (35), to which outputs of remained high-order m pieces (46C~56C) of said selected flip flops are supplied, for detecting an error pattern of said received code word, and

means (101) for supplying a control signal to said alternative circuits for changing over a shift direction of said two-way feedback shift register when said syndrome tester detects said syndrome being not zero.

9. An encoder/decoder according to claim 8, wherein said number of said flip flops in 56.

10. An encoder/decoder according to claim 9, wherein said 1 pieces are 32 pieces or 56 pieces.

11. An encoder/decoder according to claim 10, wherein said selecting means comprises a selecting circuit (71,72) inserted between the 24th flip flop from said input terminal and the 25th flip flop from said input terminal.

FIG. 1 PRIOR ART

M 18·04·86  0200124

2/7

# FIG. 2
# PRIOR ART

CODE LENGTH n

m

i

$n-\ell-i$

$\ell$

ERROR PATTERN

INSPECTION PATTERN

ERROR LOCATION

RECEIVED CODE WORD

SHIFTING NUMBER

# FIG. 3

CODE LENGTH n

j

m

$\ell$

ERROR PATTERN

INSPECTION PATTERN

RECEIVED CODE WORD

ERROR LOCATION = SHIFTING NUMBER

# FIG. 4

# FIG. 5

M 18·04·86  0200124

5/7

## FIG. 6

```
          ┌──────────┐
          │  START   │
          └────┬─────┘
               │
      ┌────────────────┐
      │ RESET FEEDBACK │──── 61
      │ SHIFT REGISTER │
      └────────┬───────┘
               │
      ┌────────────────┐
      │ INPUT RECEIVED │
      │ DATA BY FORWARD│──── 62
      │  DIRECTIONAL-  │
      │   SHIFTING     │
      └────────┬───────┘
               │
              63
         ◇────────────◇
   NO   │  SYNDROME  │
  ◄─────│   = φ ?    │
         ◇────────────◇
               │ YES
               │
      ┌────────────────┐
      │ SHIFT FEED-BACK│
      │ SHIFT REGISTER │──── 64
      │ ONCE IN THE    │
      │ REVERSED       │
      │ DIRECTION      │
      └────────┬───────┘
               │
              65
         ◇────────────◇
         │    ARE     │
         │ LOW-ORDER  │    NO
         │ 21 BITS OF │───────────┐
         │ FEEDBACK   │          66
         │ SHIFT REG. │      ◇─────────◇
         │ ALL ZERO ? │      │ SHIFTING│  NO
         ◇────────────◇      │ NUMBER= │────►
               │ YES         │ DATA    │
               │             │ LENGTH? │
               │             ◇─────────◇
               │                 │ YES
      ┌────────────────┐
      │ PROCESSING OF  │──── 67
      │ ERROR CORRECTION│
      └────────┬───────┘
               │
          ┌──────────┐
          │   END    │──── 68
          └──────────┘
```

NO ERROR

UNCORRECTABLE ERROR IS DETECTED

FIG. 7

FIG. 8